# EUROPEAN PATENT APPLICATION

(11) **EP 4 369 877 A2**
(43) Date of publication of application: **15.05.2024**
(21) Application number: 23208611.6
(22) Date of filing: 08.11.2023
(51) Int. Cl.: H05K 7/14, H05K 7/20, H02B 1/56, H02J 9/00

(54) **ELECTRICAL SYSTEM AND ELECTRICAL APPARATUS FOR STATIC TRANSFER SWITCH POWER AND COOLING**

(30) Priority: 08.11.2022 US 202218053595
(71) Applicant: ABB SCHWEIZ AG, 5400 Baden (CH)
(72) Inventor: MILLER, Gilbert T., Henrico, 23233 (US); Kendzia, Thomas Anthony, Rockville, 23146 (US)
(74) Representative: Maiwald GmbH

(57) **Abstract**

An electrical system and apparatus for powering and cooling a static transfer switch (STS) assembly are provided. The electrical system includes an STS assembly, which includes at least two silicon controlled rectifiers (SCRs) for at least one power phase of the STS assembly, where the at least two SCRs are for incoming power sources that are opposing to each other. The electrical system includes a cooling system located between the at least two SCRs for the incoming power sources that are opposing to each other for the at least one power phase of the STS assembly. The electrical system further includes a plenum structure, where the cooling system is mounted in a middle of the plenum structure, and the STS assembly is arranged around the cooling system.

## Description

### FIELD

The present disclosure generally relates to electrical systems and electrical apparatuses, and more particularly, to an electrical system and electrical apparatus for static transfer switch power and cooling.

### BACKGROUND

Systems and apparatuses for powering and cooling a static transfer switch are widely used for power system assemblies. A static transfer switch switches between electrical power sources so as to provide the highest availability of power supply. This is critical for power systems, such as data centers etc., which are sensitive to power interruptions. Cooling for a static transfer switch is an area of interest, as it prevents over-temperature and ensures proper operation of a static transfer switch. However, traditional static transfer switch assemblies allow fault propagations from one power source to another, and require separate assemblies for power and cooling as well. Moreover, traditional static transfer switch assemblies have other limitations. For example, traditional static transfer switch assemblies only have front access, and accordingly, require a large footprint and otherwise raise environmental concerns.

Therefore, there is a need to improve static transfer switch assemblies to overcome the above-discussed drawbacks. At the same time, there is a need to enhance functionalities of static transfer switch assemblies.

### SUMMARY

In an exemplary embodiment, the present disclosure provides an electrical system for static transfer switch power and cooling having physically isolated incoming power sources. The electrical system includes a static transfer switch (STS) assembly, which includes at least two silicon controlled rectifiers (SCRs) for at least one power phase of the STS assembly, wherein the at least two SCRs are for incoming power sources that are opposing to each other; and a cooling system located between the at least two SCRs for the at least one power phase of the STS assembly.

The cooling system includes one or more heatsink assemblies for the STS assembly.

The cooling system includes a first heatsink assembly located on a first side and a second heatsink assembly located on an opposing second side respectively for the at least two SCRs for the incoming power sources that are opposing to each other.

The first and second heatsink assemblies are arranged to define a barrier between the at least two SCRs for the incoming power sources that are opposing to each other for the at least one power phase of the STS assembly, and wherein outputs of the at least two SCRs for the opposing incoming power sources are connected through busbars on a back of the electrical system.

The cooling system includes a shared channel for cooling air for the one or more heatsink assemblies.

The shared channel is a structural part of a plenum structure that supports the electrical system.

The one or more heatsink assemblies are removeable from a front of the electrical system.

In an exemplary embodiment, the present disclosure provides an electrical system for static transfer switch power and cooling having a plenum structure for supporting the system and integrating a cooling system. The plenum structure for the electrical system includes a base including a first end and an opposing second end; a first supporting panel including a first end and a second end, wherein the first end of the first supporting panel is mounted on the first end of the base; a second supporting panel including a first end and a second end, wherein the first end of the second supporting panel is mounted on the opposing second end of the base; and a covering layer including a first end and a second end, wherein the second end of the first supporting panel is mounted on the first end of the covering layer, and the second end of the second supporting panel is mounted on the second end of the covering layer, and wherein one or more tracks are mounted on the base for one or more heatsink assemblies of the electrical system within space between the base and the covering layer.

The first supporting panel is perpendicular to the base and the second supporting panel is perpendicular to the base, and wherein the first supporting panel is perpendicular to the covering layer and the second supporting panel is perpendicular to the covering layer.

A static transfer switch (STS) assembly is arranged around the one or more heatsink assemblies within the space between the base and the covering layer.

The STS assembly includes at least two silicon controlled rectifiers (SCRs) for at least one power phase of the STS assembly, wherein the at least two SCRs are for incoming power sources that are opposing to each other, and the at least two SCRs for the opposing incoming power sources are arranged around the one or more heatsink assemblies, and outputs of the at least two SCRs for the opposing incoming power sources are connected through busbars on a back of the plenum structure.

The plenum structure further includes two front doors to access the one or more heatsink assemblies.

The covering layer is a cuboid without top and bottom surfaces, and the cuboid includes one or more fans for cooling air for the one or more heatsink assemblies.

In an exemplary embodiment, the present disclosure further provides an electrical system integrating a cooling system into a plenum structure for a static transfer switch having physically isolated incoming power sources. The electrical system includes a static transfer switch (STS) assembly, which includes at least two silicon controlled rectifiers (SCRs) for at least one power phase of the STS assembly, wherein the at least two SCRs are for incoming power sources that are opposing to each other; a cooling system located between the at least two SCRs for the incoming power sources that are opposing to each other for the at least one power phase of the STS assembly; and a plenum structure, and wherein the cooling system is mounted in a middle of the plenum structure, and the STS assembly is arranged around the cooling system.

### BRIEF DESCRIPTION OF THE DRAWING(S)

FIG. 1 is a perspective left front view of a static transfer switch unit and associated enclosure for an electrical system that includes a larger static transfer switch assembly and heatsink assemblies according to an exemplary embodiment of the present disclosure;
FIG. 2 is a perspective left front view of an electrical system and associated enclosure that includes a larger static transfer switch assembly and heatsink assemblies;
FIG. 3 is a front view of an electrical system and associated enclosure that includes a larger static transfer switch assembly and heatsink assemblies;
FIG. 4 is a front view of one static transfer switch phase of an electrical system that includes a larger static transfer switch assembly and heatsink assemblies;
FIG. 5 is a perspective right front view of the electrical system of, for example, FIG. 1 that includes the larger static transfer switch assembly and heatsink assemblies according to an exemplary embodiment of the present disclosure;
FIG. 6 is a top view of the electrical system of FIG. 5 according to an exemplary embodiment of the present disclosure;
FIG. 7 is a front view of the electrical system of FIG. 5 according to an exemplary embodiment of the present disclosure;
FIG. 8 is a section view taken in the plane represented by the line E-E in FIG. 7 of the electrical system of FIG. 5 according to an exemplary embodiment of the present disclosure;
FIG. 9 is a left side view of the electrical system of FIG. 5 according to an exemplary embodiment of the present disclosure;
FIG. 10 is a right side view of the electrical system of FIG. 5 according to an exemplary embodiment of the present disclosure;
FIG. 11 is a bottom view of the electrical system of FIG. 5 according to an exemplary embodiment of the present disclosure;
FIG. 12 is a perspective right front view of a plenum structure of the electrical system of, for example, FIG. 5 according to an exemplary embodiment of the present disclosure;
FIG. 13 is a section view of three heatsink billets of the heatsink assembly of the electrical system of, for example, FIG. 5 according to an exemplary embodiment of the present disclosure;
FIG. 14 is a half top view of the electrical system of, for example, FIG. 5 according to an exemplary embodiment of the present disclosure;
FIG. 15 is a half front view of the electrical system of, for example, FIG. 5 according to an exemplary embodiment of the present disclosure;
FIG. 16 is a right side view of the electrical system of, for example, FIG. 5 according to an exemplary embodiment of the present disclosure;
FIG. 17 is a perspective half right front view of the electrical system of, for example, FIG. 5 according to an exemplary embodiment of the present disclosure;
FIG. 18 is a half bottom view of the electrical system of, for example, FIG. 5 according to an exemplary embodiment of the present disclosure;
FIG. 19 is a perspective left front view of a static transfer switch unit and associated enclosure for an electrical system that includes a smaller static transfer switch assembly and heatsink assemblies according to an exemplary embodiment of the present disclosure;
FIG. 20 is a top view of the electrical system of, for example, FIG. 19 that includes the smaller static transfer switch assembly and heatsink assemblies according to an exemplary embodiment of the present disclosure;
FIG. 21 is a front view of the electrical system of FIG. 20 according to an exemplary embodiment of the present disclosure;
FIG. 22 is a section taken in the plane of line F-F in FIG. 21 view of the electrical system of FIG. 20 according to an exemplary embodiment of the present disclosure;
FIG. 23 is a left side view of the electrical system of FIG. 20 according to an exemplary embodiment of the present disclosure;
FIG. 24 is a right side view of the electrical system of FIG. 20 according to an exemplary embodiment of the present disclosure; and
FIG. 25 is a bottom view of the electrical system of FIG. 20 according to an exemplary embodiment of the present disclosure.

### DETAILED DESCRIPTION

Exemplary embodiments of the present disclosure provide an electrical system and an electrical apparatus for static transfer switch power and cooling.

Systems and apparatuses for powering and cooling static transfer switches are widely used for various applications. Such systems and apparatuses are designed to transfer critical loads between two incoming power sources without interruptions or with a relatively short transfer time.

In one exemplary embodiment of the present disclosure, an electrical system for powering and cooling a static transfer switch is provided that has physically isolated incoming power sources. In such a static transfer switch, two incoming power sources are physically separated so there will not be fault propagations from one incoming power source to the other. In addition, the static transfer switch assembly has a smaller footprint both physically and environmentally.

In one exemplary embodiment of the present disclosure, an electrical system for static transfer switch power and cooling having a plenum structure for supporting the system and integrating a cooling system is provided. In such a static transfer switch, a plenum structure for supporting the static transfer switch itself also serves as space for one or more heatsink billets, i.e., the cooling system that is integrated into the plenum structure for the static transfer switch.

For example, an electrical system includes a static transfer switch (STS) assembly, which includes at least two silicon controlled rectifiers (SCRs) for at least one power phase of the STS assembly, wherein the at least two SCRs are for incoming power sources that are opposing to each other; a cooling system located between the at least two SCRs for the incoming power sources that are opposing to each other for the at least one power phase of the STS assembly; and a plenum structure, and wherein the cooling system is mounted in a middle of the plenum structure, and the STS assembly is arranged around the cooling system.

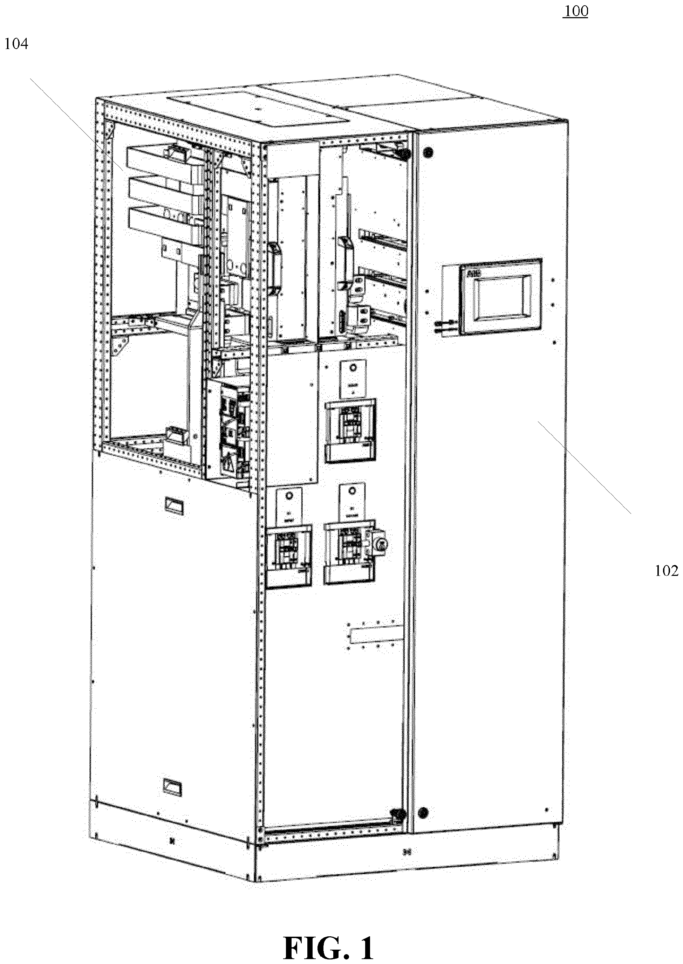

FIG. 1 is a perspective left front view of a static transfer switch unit and associated enclosure for an electrical system that includes a larger static transfer switch assembly and heatsink assemblies according to an exemplary embodiment of the present disclosure. As shown FIG. 1, in a static transfer switch (STS) unit 102, a STS assembly 104 and one or more heatsink assemblies are generally located together, for example, in the top left corner of the unit 102. The STS assembly 104 may include one or more power phases for one or more power stages. Each power phase generally includes a pair of silicon controlled rectifiers (SCRs) for respective two incoming power sources. In a traditional design, the STS assembly 104 and the one or more heatsink assemblies are separate configurations and/or assemblies, though they are located in the same location in the STS unit 102.The STS unit 102 may include other components within the enclosure, for example, in the top right corner or the lower part of the unit 102.

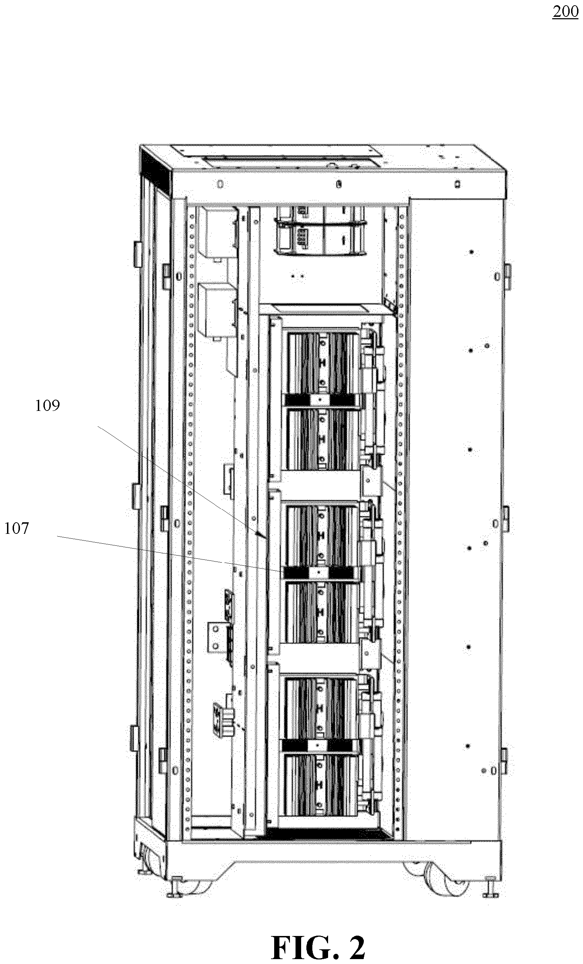

FIG. 2 is a perspective left front view of an electrical system and associated enclosure that includes a larger static transfer switch assembly and heatsink assemblies. As shown in FIG. 2, a heatsink assembly 107 includes a heatsink mounting structure 109. Typically, the heatsink mounting structure 109 fastens to the existing structure of the STS unit 102. Further, the heatsink mounting structure 109 only creates one wall of the cooling airflow passage for the heatsink assembly 107. The other walls of the cooling airflow passage are created by other components of the STS unit 102.

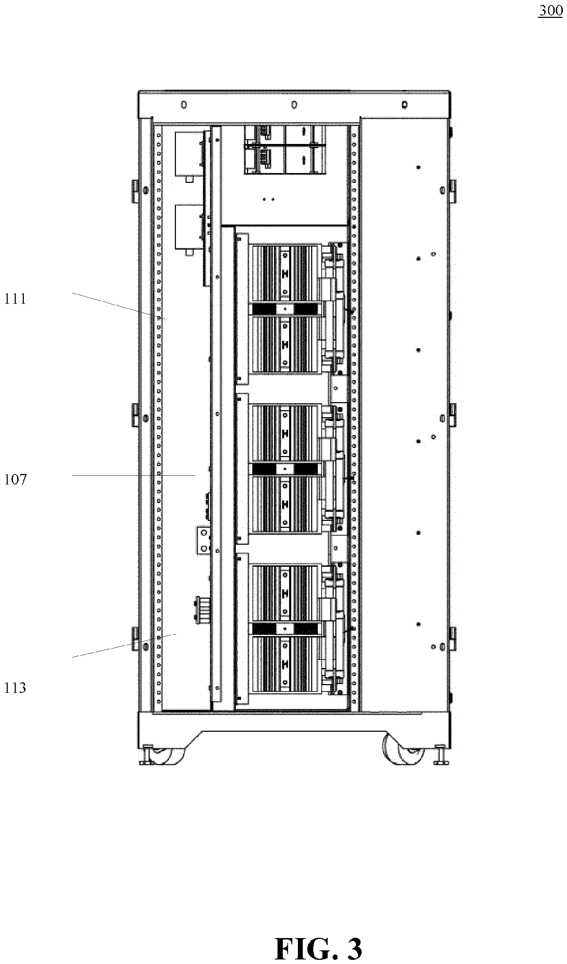

FIG. 3 is a front view of an electrical system and associated enclosure that includes a larger static transfer switch assembly and heatsink assemblies. As shown in FIG. 3, three heatsink assemblies, 107, 111, and 113, are used for the STS assembly 104 of the STS unit 102. That is, one heatsink assembly is used for each power phase of the STS assembly 104. In each power phase of the STS assembly 104, both incoming power sources are included in the same heatsink assembly, 107, 111, or 113.

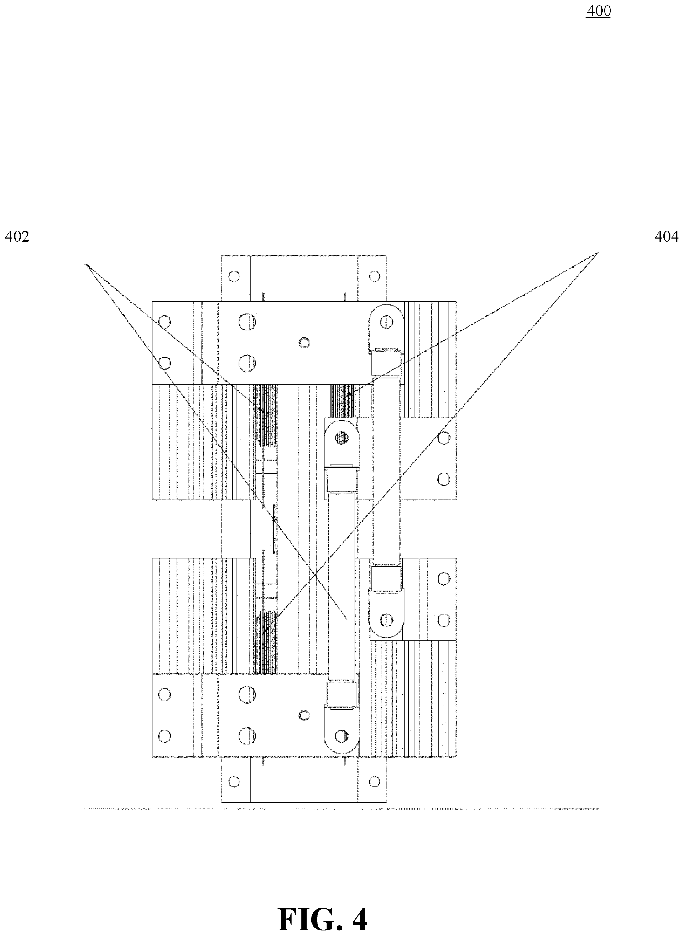

FIG. 4 is a front view of one static transfer switch phase of an electrical system that includes a larger static transfer switch assembly and heatsink assemblies. As shown in FIG. 4, 402 references one SCR of the SCR pair for each power phase of the STS assembly 104 and 404 references the other SCR of the SCR pair. For example, the SCR 402 may be for one incoming power source and the SCR 404 may be for the opposing incoming power source.

As shown, in the event of a fault and/or explosion, for example, in the SCR 402 located in the top left of the power phase of the STS assembly 104, the fault and/or explosion has a clear path to the SCR 404 located in the bottom left. Thus, the fault and/or explosion in the SCR 402 directly impacts the SCR 404. For example, this propagates the failure from one incoming power source in the SCR 402 to the opposing incoming power source in the SCR 404. This also results in a failure to maintain the load of the STS assembly 104.

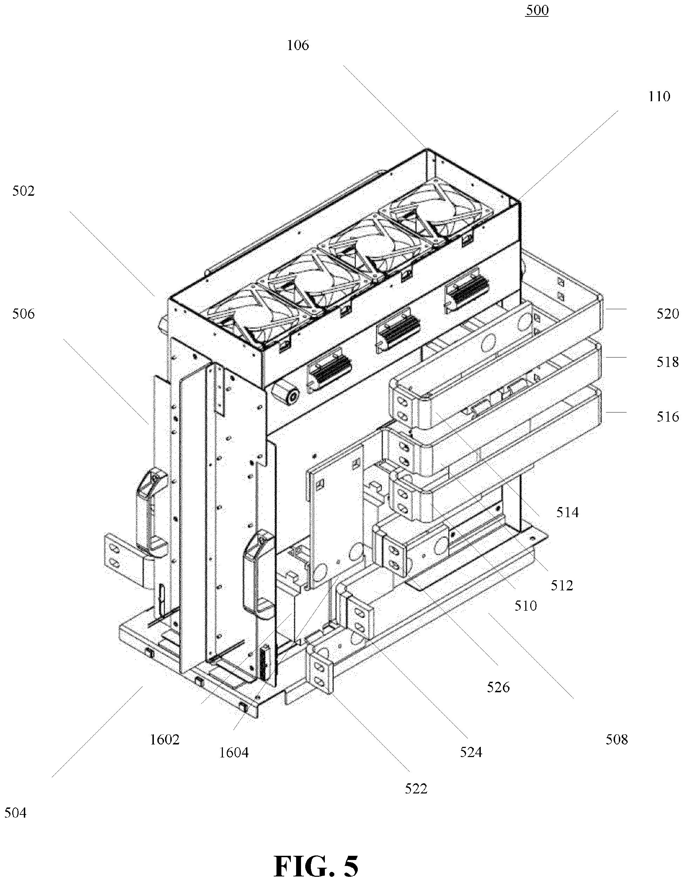

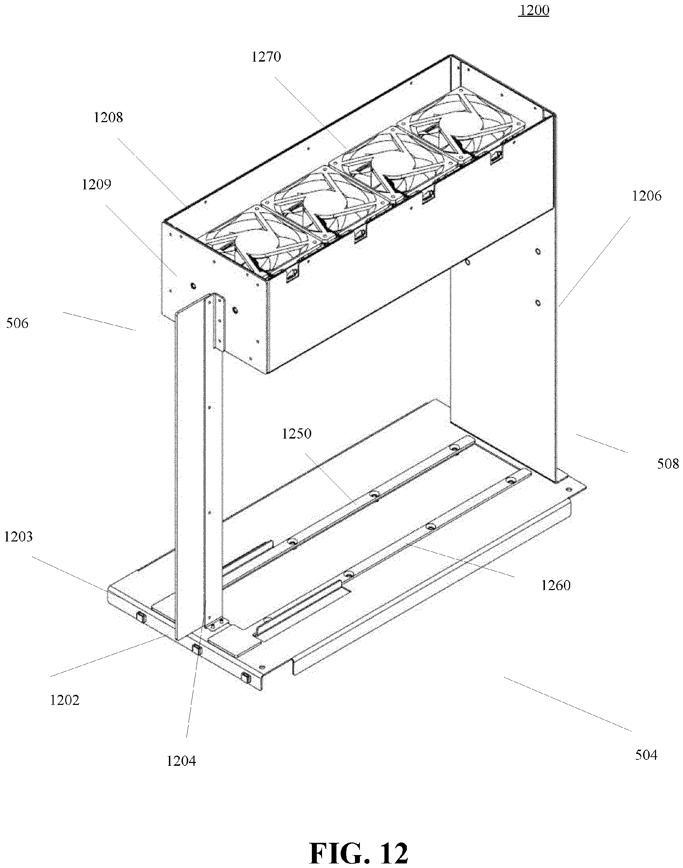

FIG. 5 is a perspective right front view of the electrical system of, for example, FIG. 1 that includes the larger static transfer switch assembly and heatsink assemblies according to an exemplary embodiment of the present disclosure. As shown in FIG. 5, an electrical system 502 for the STS assembly 104 and the one or more heatsink assemblies (for example, heatsink assemblies 106 and 110 in the middle of the electrical system 502 and surrounded by the STS assembly 104) is shown. The electrical system 502 includes a plenum structure 504 that provides both structural support for the electrical system and cooling pathways, namely, the hollow cuboid layer 1208 as shown in FIG. 12, for the one or more heatsink assemblies. For example, the air between the one or more heatsink assemblies is driven from the bottom to the top of the plenum structure 504, and then, goes through the hollow cuboid layer 1208. The electrical system 502 also includes two heatsink assemblies (for example, the heatsink assemblies 106 and 110), which are located on the left side 506 and right side 508 of the electrical system 502, respectively.

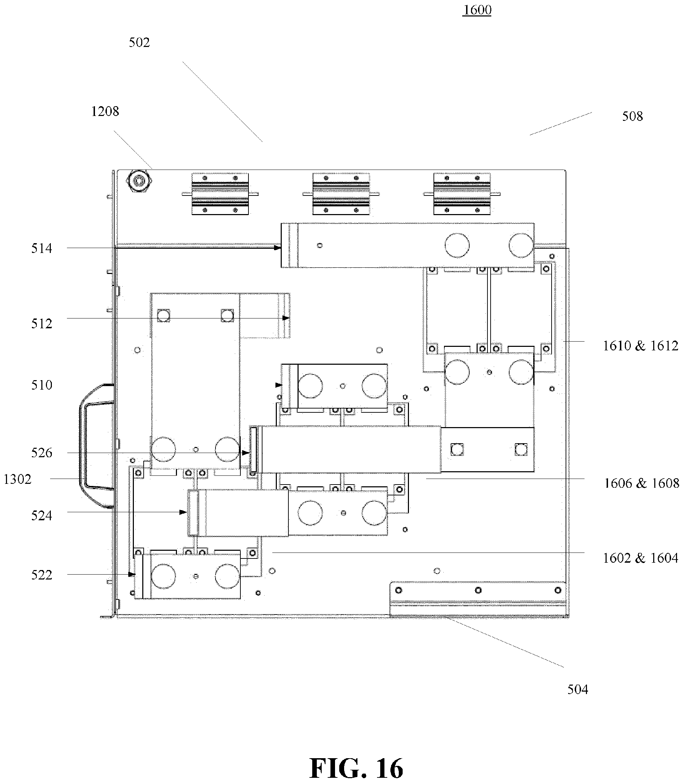

For example, on the right side 508 of the electrical system 502, there are three pairs of SCRs for the three power phases of the STS assembly 104, respectively. These three pairs of SCRs, for example, one pair of SCRs 1602 and 1604 as shown in FIG. 5 as well as in FIG. 16, are arranged around the heatsink assembly (for example, the heatsink assembly 110) located on the right side 508. Similarly, there are another three pairs of SCRs arranged around the heatsink assembly (for example, the heatsink assembly 106) located on the left side 506 of the electrical system 502. As such, the heatsink assemblies are configured to serve as a physical barrier between electronics for opposing incoming power sources.

In an exemplary embodiment of the present disclosure, only SCRs of a single incoming power source perform are conducting at one time. For example, only SCRs on the right side 508 or the left side 506 of the electrical system 502 performs conducting at one time. This is done for several reasons, including preventing out of phase sources from connecting together and preventing a load fault from impacting more than one source. Should the STS assembly 104 need to change which source is connected to the load, for example in the case of voltage sag on the active source, the control system of the STS assembly 104 will allow the active source's SCR's to commutate off fully, stopping conduction from the first source, and will then gate the alternate source's SCR's on, starting conduction on the second source. Thus, heat is generated in opposite sides of each heatsink assembly so as to improve cooling efficiency. Accordingly, sufficient cooling efficiency is maintained.

Further, on the right side 508 of the electrical system 502, the outputs, 510, 512, and 514, of the SCR pairs for the three power phases of the STS assembly 104 are tied together electrically by busbars, 516, 518, and 520, respectively, to the outputs of the left side 506 of the electrical system. In an exemplary embodiment of the present disclosure, the outputs (510, 512, and 514) are tied together by the busbars (516, 518, and 520) respectively on the back of the electrical system 502, as shown in FIG. 5.

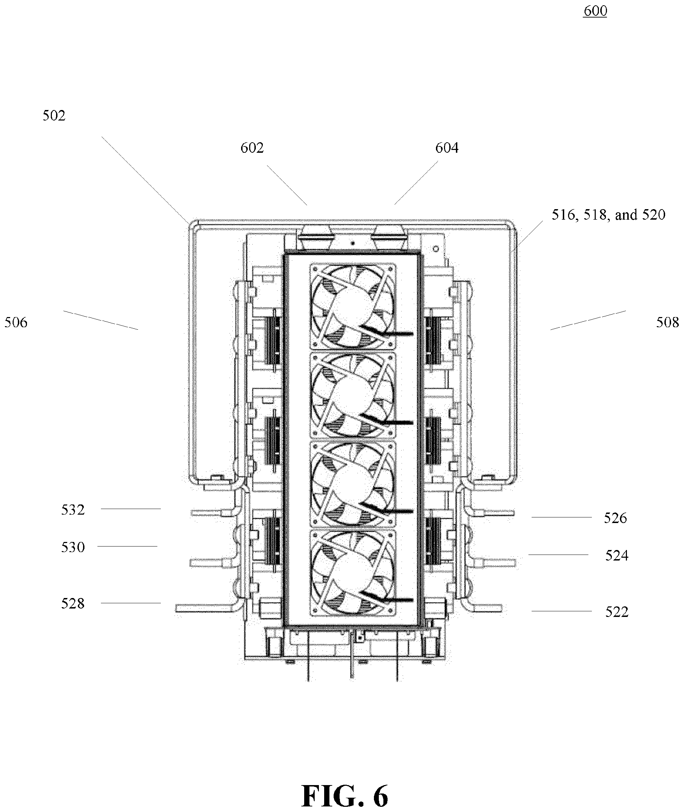

In addition, as will be described below in relation to FIG. 6, the outputs of the two heatsink assemblies (for example, the heatsink assemblies 106 and 110) are also tied together electrically by these busbars, for example, 516, 518, and 520, on the back of the electrical system 502, in order to provide one common output to the electrical system that can be fed by either of two incoming sources of power. This arrangement allows the two heatsink assemblies (for example, the heatsink assemblies 106 and 110) to stay physically isolated, while providing one common output to the system and still sharing pathways for cooling air so that environmental footprints are reduced and operational performance is enhanced.

Accordingly, in each power phase of the STS assembly 104, a catastrophic failure of one SCR for one incoming power source will not impact the other SCRs for the opposing incoming power source. In other words, this arrangement does not allow "projectiles" of one SCR for one incoming power source to contact the SCRs for the opposing incoming power source.. Accordingly, while maintaining sufficient cooling efficiency, a physical barrier between SCRs of opposing incoming power sources is created.

In an exemplary embodiment of the present disclosure, on the right side 508 of the electrical system 502, the inputs, 522, 524, and 526, of the SCR pairs for the three power phases of the STS assembly 104 can be accessed from the front of the electrical system 502. Busbars connected to the inputs of the SCR pairs for the three power phases of the STS assembly 104 allow further connections from the front of the electrical system 502 without overlap.

FIG. 6 is a top view of the electrical system of FIG. 5 according to an exemplary embodiment of the present disclosure. As shown in FIG. 6, the outputs 602 and 604 of the two heatsink assemblies are tied together electrically by the busbars, for example, the busbars 516, 518, and 520. As such, one common output for the outputs 602 and 604 of the two heatsink assemblies is provided to the electrical system.

As shown and discussed above, the inputs (522, 524, and 526) of the SCR pairs for the three power phases of the STS assembly 104 are on the right side 508 of the electrical system 502. Further, the inputs, 528, 530, and 532, of the other three SCR pairs for the three power phases of the STS assembly 104 are shown on the left side 506 of the electrical system 502.

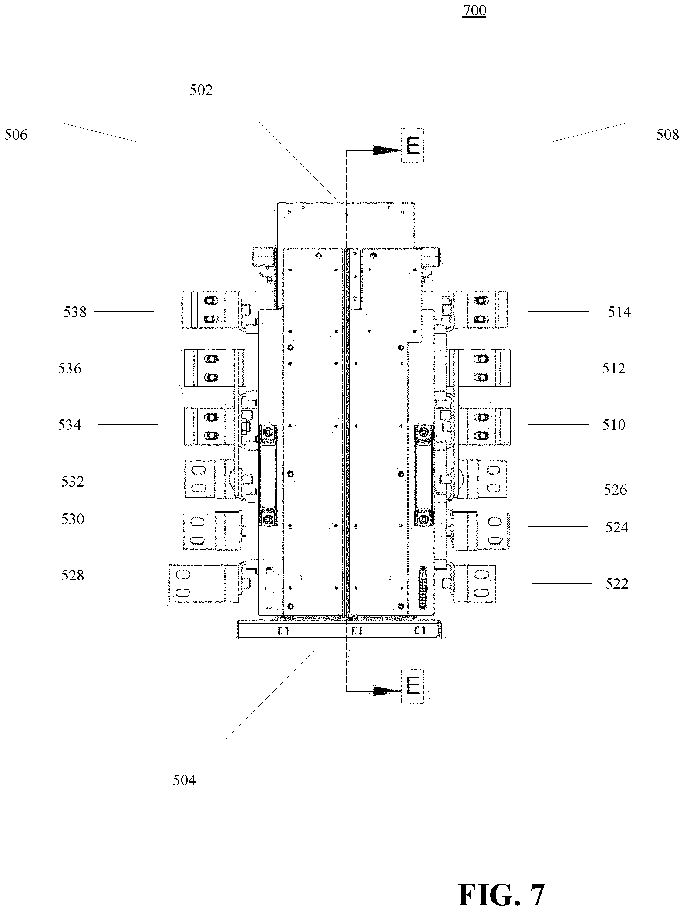

FIG. 7 is a front view of the electrical system of FIG. 5 according to an exemplary embodiment of the present disclosure. As shown in FIG. 7, there are three inputs (522, 524, and 526) and three outputs (510, 512, and 514) of the SCR pairs for the three power phases of the STS assembly 104 on the right side 508 of the electrical system 502.

Further, the outputs, 534, 536, and 538, of the other three SCR pairs for the three power phases of the STS assembly 104 are shown on the left side 506 of the electrical system 502. Thus, there are three inputs (528, 530, and 532) and three outputs (534, 536, and 538) of the other three SCR pairs for the three power phases of the STS assembly 104 on the left side 506 of the electrical system 502.

Furthermore, a section E-E is shown in FIG. 7 to indicate the heatsink assembly (for example, 106) on the left side 506 and the heatsink assembly (for example, 110) on the right side 508, which are enclosed within the plenum structure 504 for the electrical system 502. As shown and discussed above, the plenum structure 504 provides both structural support for the electrical system 502 and cooling pathways for the heatsink assemblies (for example, 106 and 110).

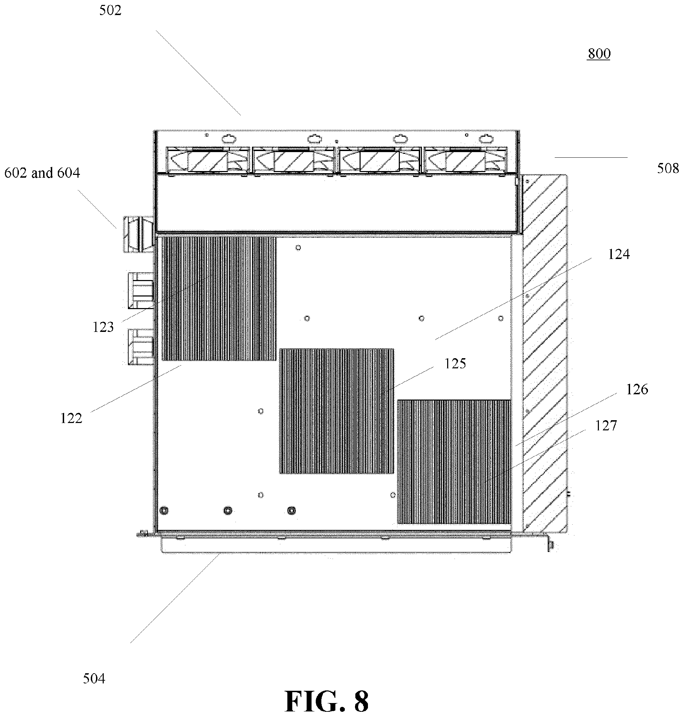

FIG. 8 is a section view taken in the plane represented by the line E-E in FIG. 7 of the electrical system of FIG. 5 according to an exemplary embodiment of the present disclosure. As shown in FIG. 8, the heatsink assembly (for example, 110) on the right side 508 of the electrical system 502 is installed within the plenum structure 504.

As shown, in the right heatsink assembly (for example, 110), there are three heatsink billets, 122, 124, and 126. These three heatsink billets (122, 124, and 126) are respectively for the three power phases of the STS assembly 104. Further, these three heatsink billets (122, 124, and 126) are made of aluminum. Additionally and/or alternatively, other materials may be also used for these three heatsink billets (122, 124, and 126).

In an exemplary embodiment of the present disclosure, the fins in each of the three heatsink billets (122, 124, and 126) of the right heatsink assembly (for example, 110) are oriented vertically. For example, the fins 123 for the heatsink billet 122, the fins 125 for the heatsink billet 124, and the fins 127 for the heatsink billet 126 are oriented vertically, as shown in FIG. 8. This orientation of the fins aligns with the cooling air channel that is created by the plenum structure 504 of the electrical system 502. Additionally and/or alternatively, the orientation of the fins and the cooling air channel may be vertical as shown in FIG. 8 and/or horizontal.

In an exemplary embodiment of the present disclosure, the height of each of the three heatsink billets (122, 124, and 126) of the right heatsink assembly (for example, 110) is significantly lower than the height of the plenum structure 504. This allows the three heatsink billets (122, 124, and 126) to be staggered as shown in FIG. 8. Such a staggered layout of the three heatsink billets (122, 124, and 126) further enables power connections to the SCRs that are mounted on the left side 506 to all be accessible. For example, the power connections to the SCRs mounted on the left side 506 can be accessed from the front of the electrical system 502 without overlapping one with another.

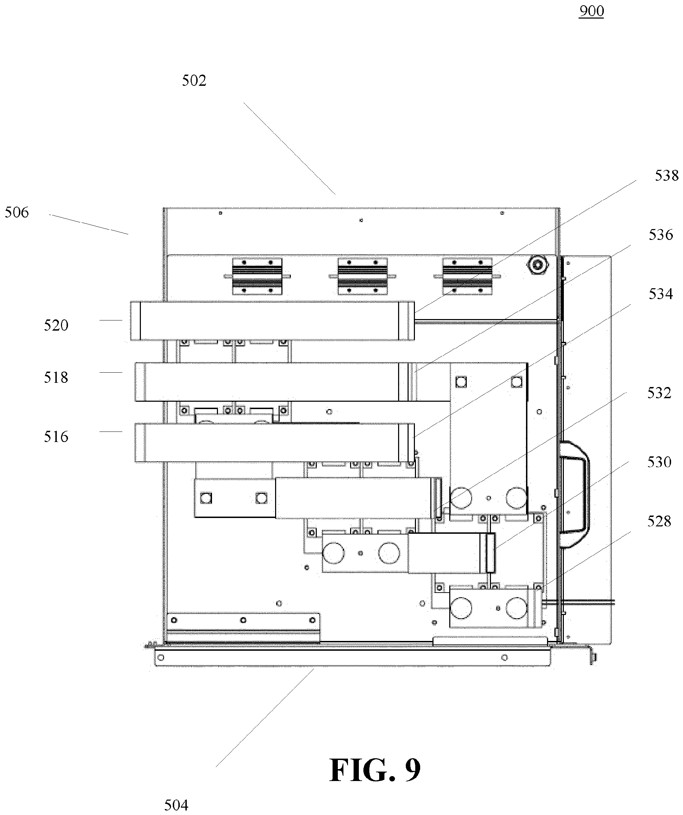

FIG. 9 is a left side view of the electrical system of FIG. 5 according to an exemplary embodiment of the present disclosure. As shown in FIG. 9, there are the outputs, 534, 536, and 538, of another three SCR pairs for the three power phases of the STS assembly 104 on the left side 506 of the electrical system 502. These outputs are tied together electrically by the busbars, 516, 518, and 520, respectively with the outputs from the STS assembly 104 on the right side 508 of the electrical system. In an exemplary embodiment of the present disclosure, the outputs (534, 536, and 538) are tied together by the busbars (516, 518, and 520) respectively on the back of the electrical system 502, as shown in FIG. 9.

The inputs, 528, 530, and 532, of another three SCR pairs for the three power phases of the STS assembly 104 on the left side 506 of the electrical system 502 are also shown in FIG. 9. As discussed above, the busbars connected to the inputs (528, 530, and 532) of the other SCR pairs for the three power phases of the STS assembly 104 allow further connections from the front of the electrical system 502 without overlap.

As further shown in FIG. 9, the plenum structure 504 provides both structural support for the electrical system 502 and the cooling pathways for the heatsink assembly (for example, the heatsink assembly 106) on the left side 506 of the electrical system 502.

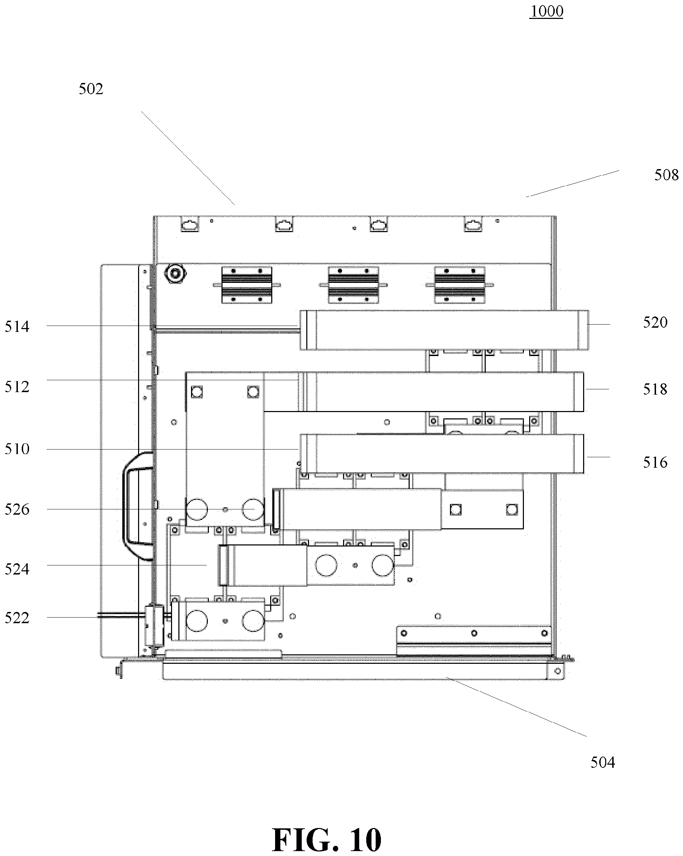

FIG. 10 is a right side view of the electrical system of FIG. 5 according to an exemplary embodiment of the present disclosure. As shown in FIG. 10, and with reference to FIG. 5, the outputs (510, 512, and 514) of the SCR pairs for the three power phases of the STS assembly 104 on the right side 508 are tied together electrically with the outputs from the STS assembly 104 on the left side 506 of the electrical system. For example, these outputs are tied together by the busbars (516, 518, and 520) respectively on the back of the electrical system 502.

On the right side 508 of the electrical system 502, the inputs (522, 524, and 526) of the SCR pairs for the three power phases of the STS assembly 104 can be accessed from the front of the electrical system 502 without overlap, as shown in FIG. 10.

As further shown in FIG. 10, the plenum structure 504 provides both structural support for the electrical system 502 and the cooling pathways for the heatsink assembly (for example, the heatsink assembly 110) on the right side 508 of the electrical system 502.

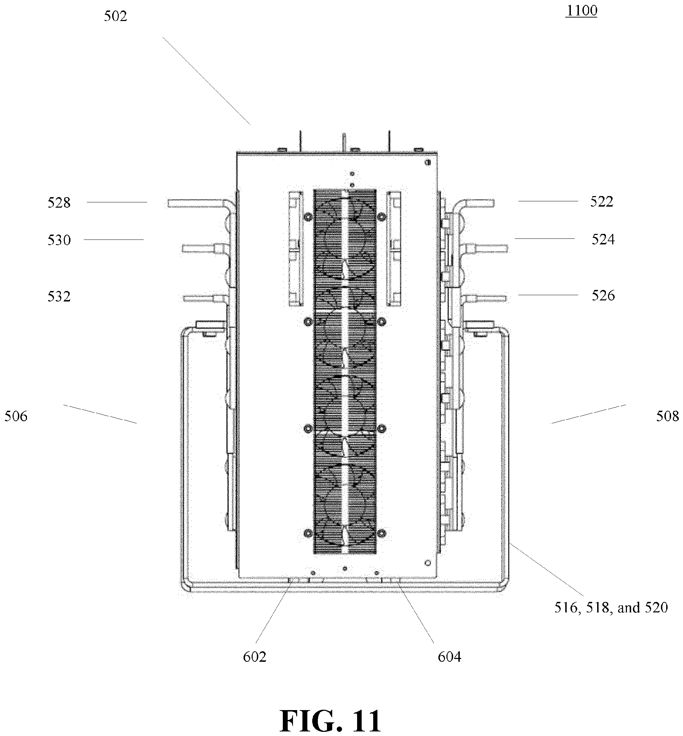

FIG. 11 is a bottom view of the electrical system of FIG. 5 according to an exemplary embodiment of the present disclosure. As shown in FIG. 11, and with reference to FIG. 6, there are inputs (522, 524, and 526) of the SCR pairs for the three power phases of the STS assembly 104 on the right side 508 of the electrical system 502. Further, the inputs (528, 530, and 532) of the other three SCR pairs for the three power phases of the STS assembly 104 are shown on the left side 506 of the electrical system 502.

As further shown in FIG. 11, the output 602 for the heatsink assembly (for example, 106) on the left side 506 and the output 604 for the heatsink assembly (for example, 110) on the right side 508 are tied together electrically by the busbars (516, 518, and 520). As discussed above, through the busbars (516, 518, and 520), one common output for the outputs 602 and 604 of the both heatsink assemblies is provided to the electrical system.

Exemplary embodiments of the present disclosure further provide a plenum structure of an electrical system. The plenum structure provides structural support for the electrical system and serves as the cooling pathways for the heatsink assemblies located on the left and right sides of the electrical system. The plenum structure further enables the left and right heatsink assemblies to be configured as a physical barrier between opposing incoming power sources of the static transfer switch assembly of the electrical system. The plenum structure also enables the left and right heatsink assemblies to allow each incoming power source of the static transfer switch assembly to be removable independently from the front of the electrical system. For example, if one side of the electrical system is under maintenance, the other side of the electrical system is able to remain in place without being removed.

FIG. 12 is a perspective right front view of a plenum structure of the electrical system of, for example, FIG. 5 according to an exemplary embodiment of the present disclosure. As shown in FIG. 12, a plenum structure of an electrical system, for example, the plenum structure 504, includes a base 1202. The base 1202 may be rectangular, as shown in FIG. 12. Additionally and/or alternatively, the base 1202 may be also other shapes. An end of a supporting panel 1204 is mounted at the one end of the base 1202, for example, at an end of the base 1202 with a shorter length, the end 1203 as shown in FIG. 12. Another supporting panel 1206 is mounted at the opposite end of the base 1202. As shown, the supporting panel 1204 is perpendicular to the base 1202, and the supporting panel 1206 is perpendicular to the base 1202 as well. Further, the supporting panel 1204 is parallel to the supporting panel 1206.

The plenum structure 504 further includes a cover layer 1208, which is basically a cuboid layer without top or bottom, namely, a hollow cuboid layer, as shown in FIG. 12. Another end of the supporting panel 1204 is mounted on a side of the hollow cuboid layer 1208, for example, on the smallest side of the hollow cuboid layer 1208, the side 1209 as shown in FIG. 12. Similarly, another end of the supporting panel 1206 is mounted on the opposite side of the hollow cuboid layer 1208. As shown, the supporting panel 1204 is perpendicular to the hollow cuboid layer 1208, and the supporting panel 1206 is perpendicular to the hollow cuboid layer 1208 as well. Further, the base 1202 is parallel to the hollow cuboid layer 1208. As such, the supporting panels 1204 and 1206 support the hollow cuboid layer 1208, which serves as a cover layer for the plenum structure 504.

In an exemplary embodiment of the present disclosure, the supporting panel 1204 and the supporting panel 1206 may be the same height. Additionally and /or alternatively, the supporting panel 1204 and the supporting panel 1206 may be different heights. For example, the supporting panel 1206 is higher than the supporting panel 1204 so that a part of the supporting panel 1206 is one side of the hollow cuboid layer 1208, or the part of the supporting panel 1206 overlaps one side of the hollow cuboid layer 1208.

In an exemplary embodiment of the present disclosure, the supporting panel 1204 is oriented so as to serve as a separator in the middle of the base 1202 and the hollow cuboid layer 1208. Accordingly, a heatsink assembly (for example, 106) is installed on the left side 506 of the plenum structure 504 within the space between the base 1202 and the hollow cuboid layer 1208. For example, the heatsink assembly (for example, 106) is installed on the track 1250 mounted on the left side of the base 1202 of the plenum structure 504. Likewise, a second heatsink assembly (for example, 110) is installed on the right side 508 of the plenum structure 504 within the space between the base 1202 and the hollow cuboid layer 1208. For example, the heatsink assembly (for example, 110) is installed on the track 1260 mounted on the right side of the base 1202 of the plenum structure 504.

Further, because the supporting panel 1204 is so oriented to be used as a separator, and also because the staggered arrangement of the three heatsink billets within each heatsink assembly as shown in FIG. 8, the left heatsink assembly (for example, 106) can be accessed from the front left side of the plenum structure 504. Likewise, the right heatsink assembly (for example, 110) can be accessed from the front right side of the plenum structure 504.

Furthermore, the left and right heatsink assemblies (for example, 106 and 110) within the space between the base 1202 and the hollow cuboid layer 1208 serve as a physical barrier between the SCR pairs for the two opposing sources of incoming power of the STS assembly 104. With reference to FIG. 5, on the right side 508, three pairs of SCRs are arranged around the heatsink assembly (for example, 110), i.e., mounted on the right wall of the plenum structure 504, and conduct three phases of one source of incoming power. Likewise, on the left side 506, another three pairs of SCRs are arranged around the heatsink assembly (for example, 106), i.e., mounted on the left wall of the plenum structure 504, and conduct three phases of a second source of incoming power. As such, arcing or conductive debris expelled from a failed SCR will not come into contact with SCRs or busbar on a second source, for example, a second source for opposing incoming power.

The supporting panel 1206, on the other hand, is oriented so as to serve as a cover for the back of plenum structure 504, as shown in FIG. 12. The busbars (for example, 516, 518, and 520, as shown in FIG. 5) for the outputs of the STS assembly 104 and of the left and right heatsink assemblies (for example, 106 and 110) are arranged around the back of plenum structure 504.

In an exemplary embodiment of the present disclosure, the hollow provided by the hollow cuboid layer 1208 serves as a container for a cooling system, such as, one or more cooling fans 1270, as shown in FIG. 12. Further, when the two heatsink assemblies (for example, 106 and 110) are installed on the left side 506 and right side 508 of the plenum structure 504, the hollow cuboid layer 1208 becomes a shared pathway for cooling air of both heatsink assemblies (for example, 106 and 110). For example, the air between the both heatsink assemblies is driven from the bottom to the top of the plenum structure 504, and then, goes through the hollow cuboid layer 1208.

As discussed, the entire plenum structure 504 may be made of aluminum. Additionally and/or alternatively, the entire plenum structure 504 may be also made of other materials. Additionally and/or alternatively, each single component of the plenum structure 504 (for example, the base 1202, the supporting panels 1204 and 1206, and the hollow cuboid layer 1208) may be made of different materials.

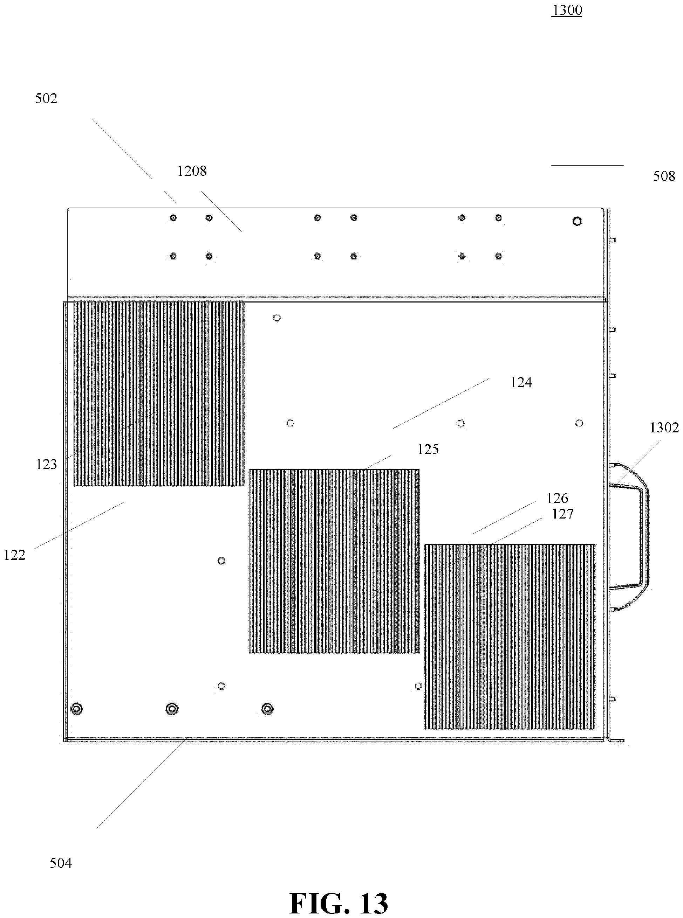

FIG. 13 is a section view of three heatsink billets of the heatsink assembly of the electrical system of, for example, FIG. 5 according to an exemplary embodiment of the present disclosure. As shown in FIG. 13, there is the right heatsink assembly (for example, 110) installed within the plenum structure 504 on the right side 508. This view is the same view from the section E-E as illustrated in FIG. 7.

As shown, there is a handle 1302 on the front right side of the plenum structure 504. The handle 1302 can be used to open the front right side of the plenum structure 504 so as to easily access the right heatsink assembly (for example, 110). The inner structure of the right heatsink assembly (for example, 110), including the staggered arrangement of the three heatsink billets (122, 124, and 126) and the vertical orientation of the fins (123, 125, and 127) within each of the three heatsink billets, is described above in connection with FIG. 8.

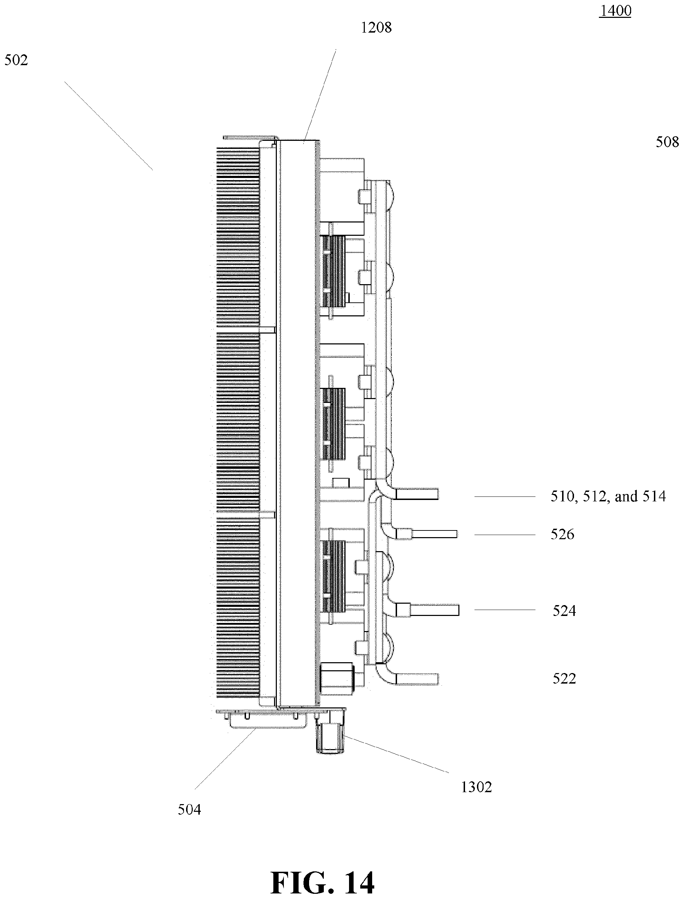

FIG. 14 is a half top view of the electrical system of, for example, FIG. 5 according to an exemplary embodiment of the present disclosure. As shown in FIG. 14, it is a right half of the electrical system 502. On the top of the plenum structure 504, the hollow cuboid layer 1208 is shown. On the front of the plenum structure 504, the handle on the right side 508 is shown.

Further, on the right side 508 of the plenum structure 504, the inputs (522, 524, and 526) of the SCR pairs for the three power phases of the STS assembly 104 of the electrical system 502 are shown. These inputs can be accessed from the front of the plenum structure 504. The outputs (510, 512, and 514) of the SCR pairs for the three power phases of the STS assembly 104 are also shown. From the perspective half top view 1400, these outputs overlap. The details of the inputs and outputs are described above in connection with FIG. 6.

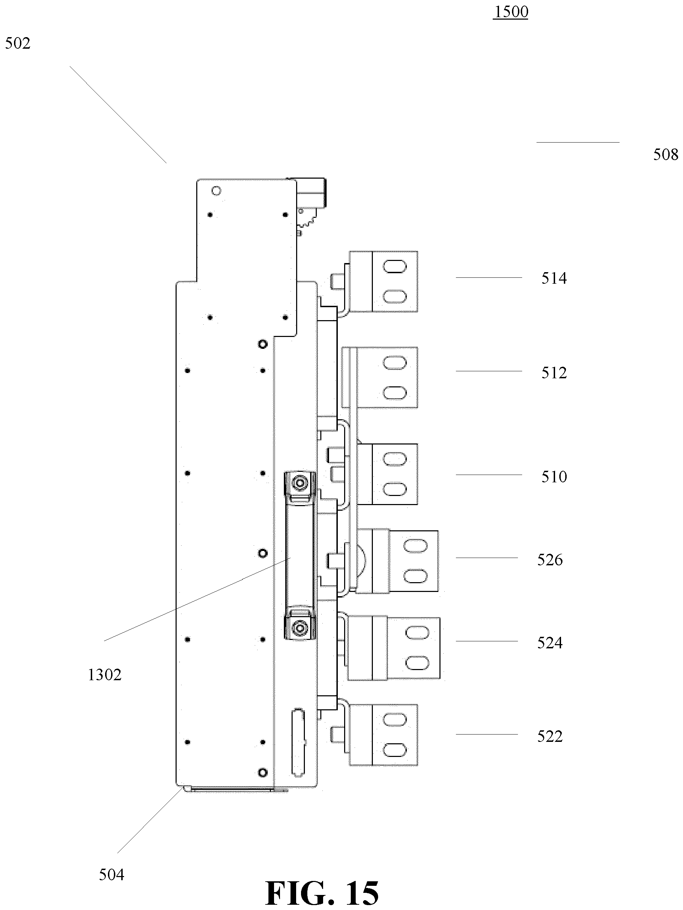

FIG. 15 is a half front view of the electrical system of, for example, FIG. 5 according to an exemplary embodiment of the present disclosure. As shown in FIG. 15, the inputs (522, 524, and 526) of the SCR pairs for the three power phases of the STS assembly 104 of the electrical system 502 can be easily accessed from the front of the plenum structure 504. The overlapped outputs (510, 512, and 514) of the SCR pairs for the three power phases of the STS assembly 104 shown in FIG. 14 can be now seen. For example, the lowest output is 510, the highest output is 514, and the output 512 is located between the outputs 510 and 514. The handle 1302 is also shown on the right side 508 of plenum structure 504.

FIG. 16 is a right side view of the electrical system of, for example, FIG. 5 according to an exemplary embodiment of the present disclosure. As shown in FIG. 16, apart from the inputs (522, 524, and 526) and the outputs (510, 512, and 514) of the SCR pairs for the three power phases of the STS assembly 104, the three SCR pairs, pair 1602 & 1604, pair 1606 & 1608, and pair 1610 & 1612, are also depicted. As can be seen, when a SCR pair is used for each power phase of the STS assembly 104, a lot of space is taken up. Thus, the plenum structure 504 for such STS assembly 104 needs to provide a significant volume. Some of the details of the inputs (522, 524, and 526) and the outputs (510, 512, and 514) of the three SCR pairs can be referenced to the description herein associated with FIG. 10.

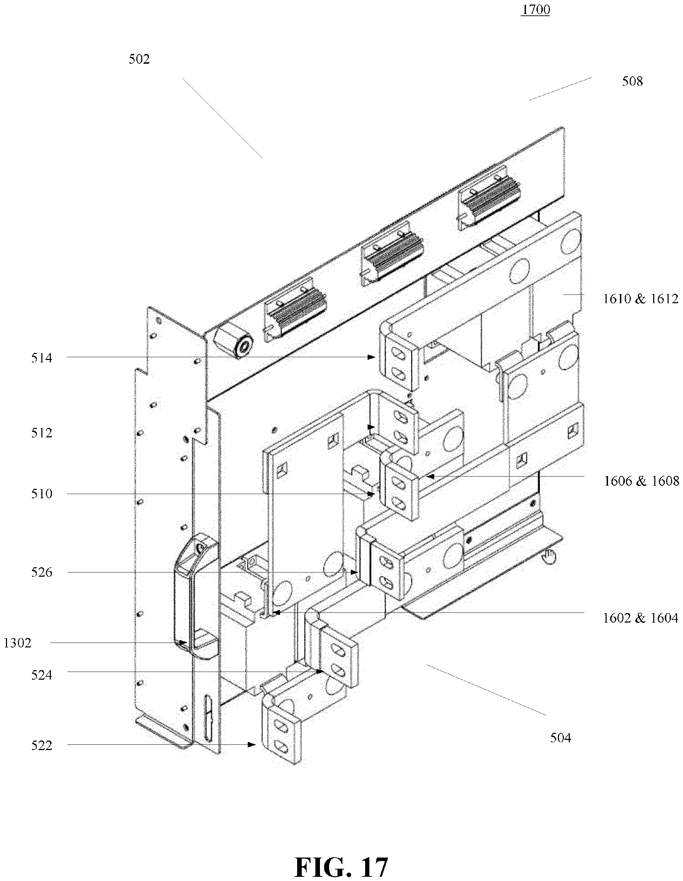

FIG. 17 is a perspective half right front view of the electrical system of, for example, FIG. 5 according to an exemplary embodiment of the present disclosure. As shown in FIG. 17, there are the inputs (522, 524, and 526) and the outputs (510, 512, and 514) of the three SCR pairs for the three power phases of the STS assembly 104 of the electrical system 502. The handle 1302 on the right side 508 of the plenum structure 504 is also shown. Some of the details of the inputs (522, 524, and 526) and the outputs (510, 512, and 514) of the three SCR pairs are described above in connection with FIG. 5.

Further, the space taken up by the three SCR pairs (1602 & 1604, 1606 & 1608, and 1610 & 1612) for the three power phases of the STS assembly 104 is more clearly shown in FIG. 17 compared with FIG. 16. As shown, in order to accommodate a larger static transfer switch assembly (for example, STS assembly 104 described herein), the plenum structure 504 needs to be designed to be more spacious.

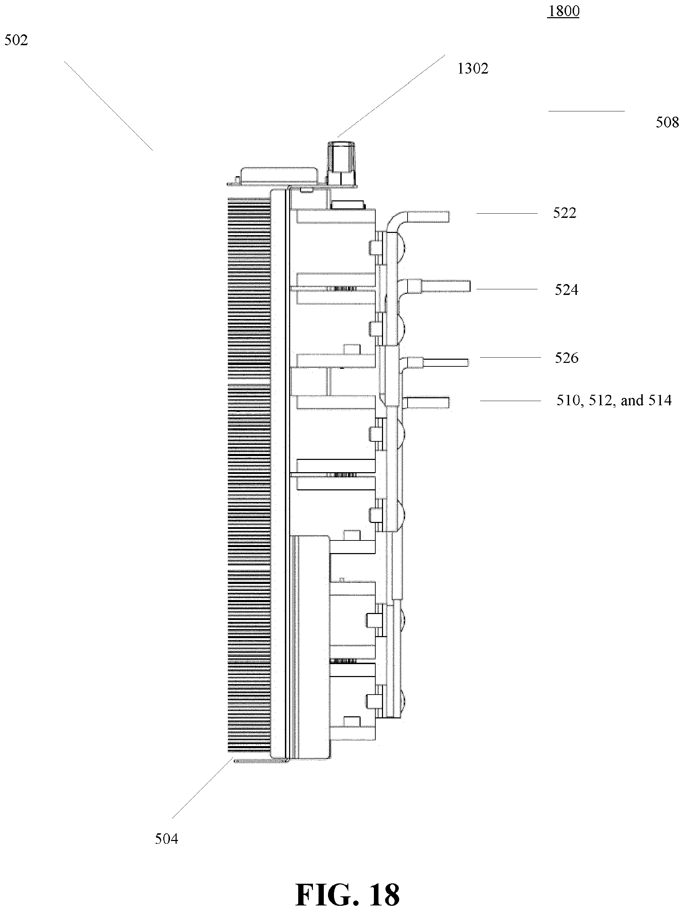

FIG. 18 is a half bottom view of the electrical system of, for example, FIG. 5 according to an exemplary embodiment of the present disclosure. As shown in FIG. 18, there are the inputs (522, 524, and 526) of the SCR pairs for the three power phases of the STS assembly 104 of the electrical system 502 on the right side 508 of the plenum structure 504. The overlapped outputs (510, 512, and 514) of the SCR pairs for the three power phases of the STS assembly 104 from the bottom view are also shown. The details of the inputs and outputs are described above with reference to FIG. 14.

Exemplary embodiments of the present disclosure further provides an electrical system for a smaller static transfer switch assembly. For example, in a smaller static transfer switch assembly, a single SCR is used for each power phase rather than a pair of SCRs for each power phase in a larger static transfer switch assembly. Because less SCRs are used in a smaller static transfer switch assembly, less space is needed for such an assembly within a plenum structure.

Other than the space difference, the electrical system and the plenum structure for the electrical system are the same as those of for a larger static transfer switch assembly. For example, the electrical system and the plenum structure therefor include both power and cooling elements for both power sources of a static transfer switch. The cooling elements include heatsink assemblies that are configured to serve as a physical barrier between electronics for opposing power sources of the static transfer switch. Further, the heatsink assembly for each power source of the static transfer switch is accessible from the front of the electrical system, i.e., from the front of the plenum structure. As such, if maintenance for one side of the electrical system is needed, the other side of the electrical system still works as designed. Furthermore, all the heatsink assemblies share a common airflow pathway, which is also a structural part of the plenum structure for electrical system.

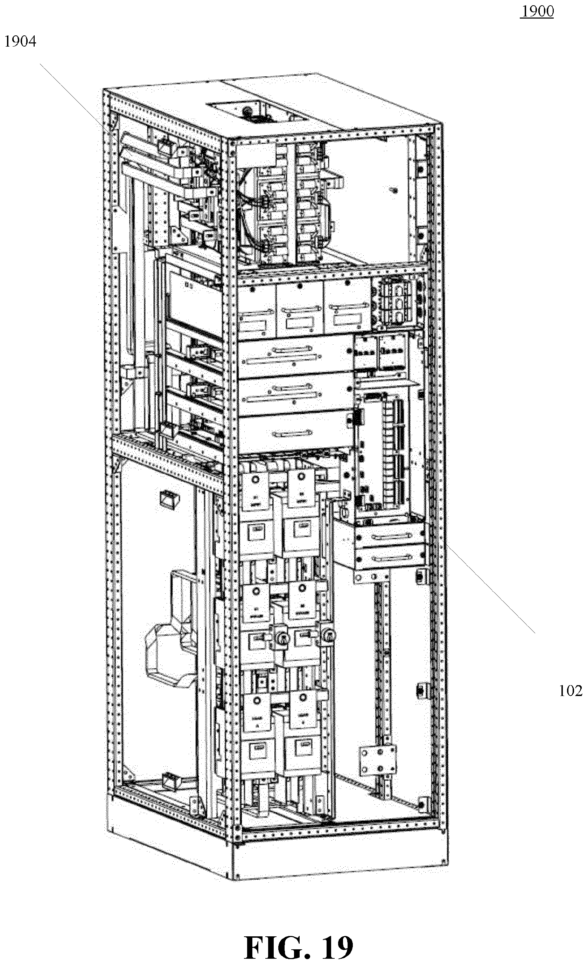

FIG. 19 is a perspective left front view of a static transfer switch unit and associated enclosure for an electrical system that includes a smaller static transfer switch assembly and heatsink assemblies according to an exemplary embodiment of the present disclosure. As shown in FIG. 19, a smaller STS assembly 1904 and one or more heatsink assemblies are located together in the top left corner of a STS unit 102 (without enclosure).

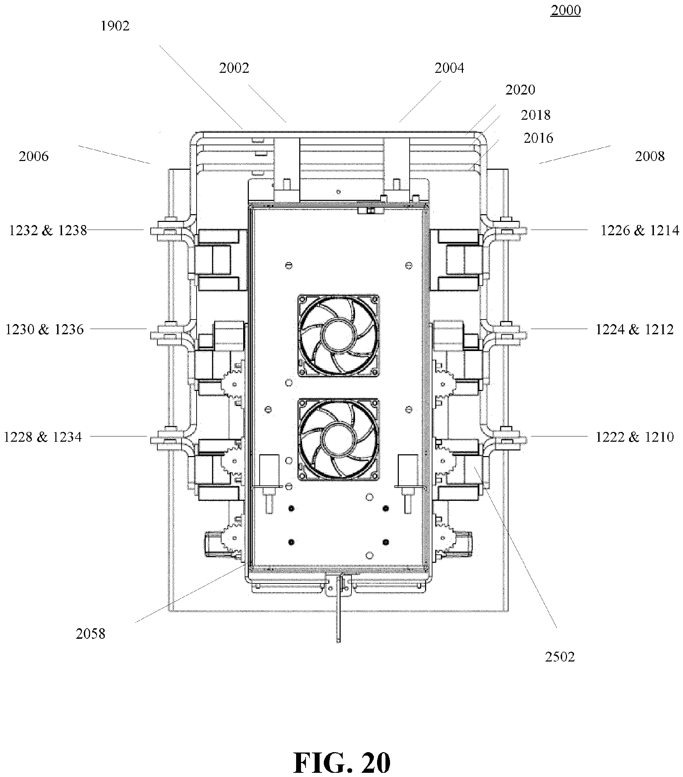

FIG. 20 is a top view of the electrical system of, for example, FIG. 19 that includes the smaller static transfer switch assembly and heatsink assemblies according to an exemplary embodiment of the present disclosure. As shown in FIG. 20, the electrical system 1902 is for a smaller STS assembly 1904. On the right side 2008, an input and an output for each single SCR for each power phase of the smaller STS assembly 1904 overlap from the perspective top view 2000. For example, from the perspective top view 2000, the input 1222 overlaps the output 1210 for one SCR, for example, the SCR 2502, for one power phase of the smaller STS assembly 1904. Likewise, the input 1224 overlaps the output 1212 for a second SCR, and the input 1226 overlaps the output 1214 for a third SCR. For example, on the left side 2006, the input 1228 overlaps the output 1234 for one SCR for one power phase of the smaller STS assembly 1904. Likewise, the input 1230 overlaps the output 1236 for a second SCR, and the input 1232 overlaps the output 1238 for a third SCR.

Further, the busbars on the back of the electrical system 1902, for example, the busbars 2016, 2018, and 2020, connect the outputs of the both right and left sides of the SCRs for the three power phases of the smaller STS assembly 1904. For example, the busbar 2016 connects the outputs 1210 and 1234 of the SCRs on the both right and left sides 2008 and 2006. Likewise, the busbar 2018 connects the outputs 1212 and 1236 of the SCRs on the both right and left sides 2008 and 2006. The busbar 2020 connects the outputs 1214 and 1238 of the SCRs on the both right and left sides 2008 and 2006.

As such, the SCRs for opposing incoming power sources for each power phase of the smaller STS assembly 1904 are physically isolated. At the same time, the outputs of these SCRs are connected through the busbars (2016, 2018, and 2020). Further, the physical isolation between the SCRs for opposing incoming power sources for each power phase is made through a cooling system, for example, one or more heatsink assemblies, which is arranged between these SCRs, i.e., located in the middle of the electrical system 1902. From the perspective top view 2000 as shown in FIG. 20, a hollow cuboid layer 2058 provided by a plenum structure for the electrical system 1902 becomes a shared pathway for cooling air for the one or more heatsink assemblies. As shown, the hollow cuboid layer 2058 holds two fans for cooling air. Additionally and/or alternatively, other equipment may be also used within the hollow cuboid layer 2058 for cooling air. Furthermore, outputs of the one or more heatsink assemblies, for example, the outputs 2004 and 2002, are also connected through the busbars (2016, 2018, and 2020) so as to provide one common output to the electrical system that can be fed by either of two incoming sources of power.

The details of the inputs and outputs, the connection between the outputs, and the accessibility of the inputs can be referenced to the description herein according to FIG. 6.

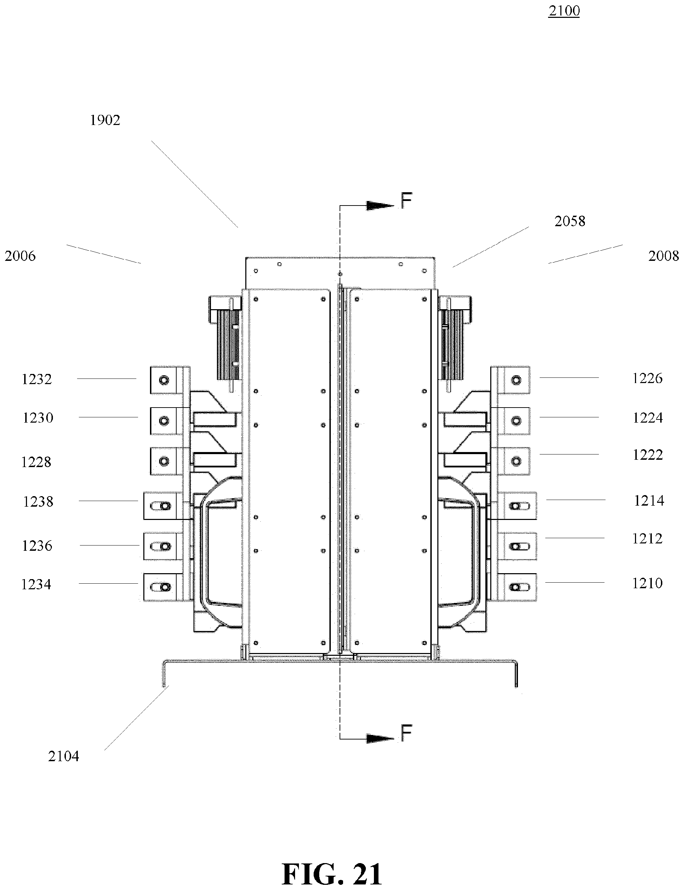

FIG. 21 is a front view of the electrical system of FIG. 20 according to an exemplary embodiment of the present disclosure. As shown in FIG. 21, there are inputs (1222, 1224, and 1226) and outputs (1210, 1212, and 1214) of the SCRs for the three power phases of the smaller STS assembly 1904 on the right side 2008. Further, there are inputs (1228, 1230, and 1232) and outputs (1234, 1236, and 1238) of the SCRs for the three power phases of the smaller STS assembly 1904 on the left side 2006. Some of the details of the inputs and outputs are described above in connection with FIG. 7.

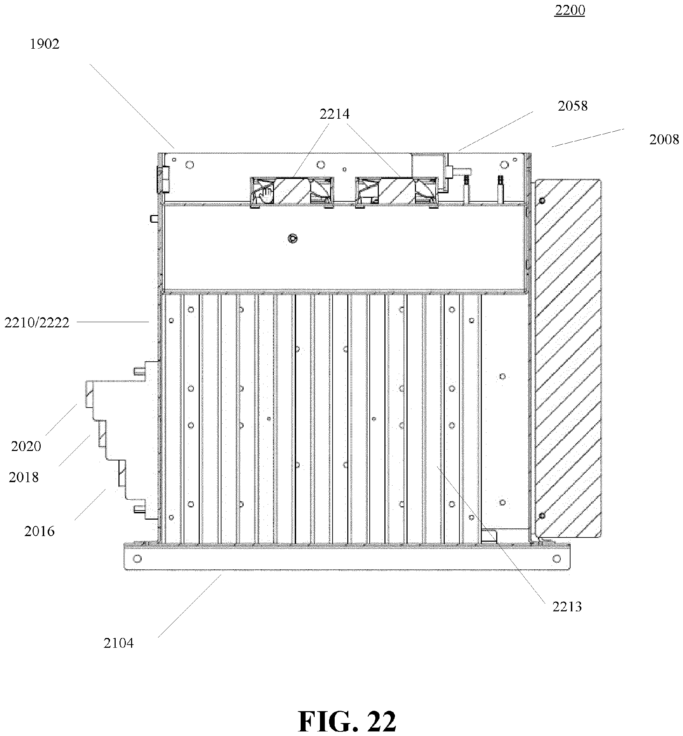

The hollow cuboid layer 2058 for the electrical system 1902 is on the top of the plenum structure, for example, the plenum structure 2104, as shown in FIG. 21. Further, a section F-F shown in FIG. 21 indicates a midline of a cooling system. The midline divides the cooling system, namely, there is a left side heatsink assembly and a right side heatsink assembly of the overall cooling system. For example, the heatsink assembly 2210 on the right side 2008 is shown in the following FIG. 22, which is enclosed within the plenum structure 2104 for the electrical system 1902.

FIG. 22 is a section taken in the plane of line F-F in FIG. 21 view of the electrical system of FIG. 20 according to an exemplary embodiment of the present disclosure. As shown in FIG. 22, from the middle view, namely, the perspective section F-F view, of the plenum structure 2104 for the electrical system 1902, there is a heatsink assembly 2210 on the right side 2008 of the electrical system 1902. In an exemplary embodiment of the present disclosure, the heatsink assembly 2210 may include one heatsink billet, for example, the heatsink billet 2222, as shown in FIG. 22.

The heatsink billet 2222 includes fins, for example, the fins 2213 as shown in FIG. 22, for cooling. For example, the fins 2213 are oriented vertically. This orientation of the fins align with the cooling air channel that is created by the plenum structure 2104 of the electrical system 1902. Additionally and/or alternatively, the orientation of the fins and the cooling air channel may be also horizontal.

The details of heatsink billets and fins are described above in connection with FIG. 8.

As shown, the hollow cuboid layer 2058 is located on the top of the plenum structure 2104. The hollow cuboid layer 2058 serves a shared channel/pathway for cooling air for the heatsink assemblies. For example, the fans 2214 within the hollow cuboid layer 2058 are used for cooling air. Further, as shown, the hollow cuboid layer 2058 also serves as a physical barrier between the SCRs on the left and right sides for the three power phases of the smaller STS assembly 1904. As such, fault propagation from one power source to another is eliminated while outputs of these SCRs are still connected through the busbars (2016, 2018, and 2020) on the back of the plenum structure 2104.

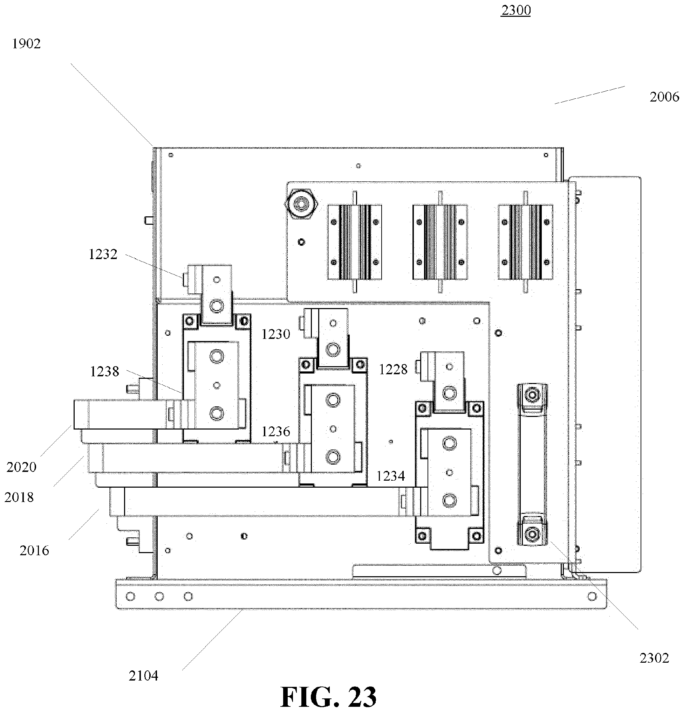

FIG. 23 is a left side view of the electrical system of FIG. 20 according to an exemplary embodiment of the present disclosure. As shown in FIG. 23, there are the inputs (1228, 1230, and 1232) and outputs (1234, 1236, and 1238) of the SCRs for the three power phases of the smaller STS assembly 1904 on the left side 2006. Further, the outputs (1234, 1236, and 1238) are connected through the busbars (2016, 2018, and 2020) on the back of the plenum structure 2104 for the electrical system 1902. The details of the inputs and outputs can be referenced to the descriptions herein according to FIG. 9 and FIG. 21.

As shown, there is a handle, for example, the handle 2302 on the left side 2006 of the plenum structure 2104. The handle 2302 is used to open the front of the plenum structure 2104 for the electrical system 1902 so that the inputs (1228, 1230, and 1232) of the SCRs can be accessed conveniently.

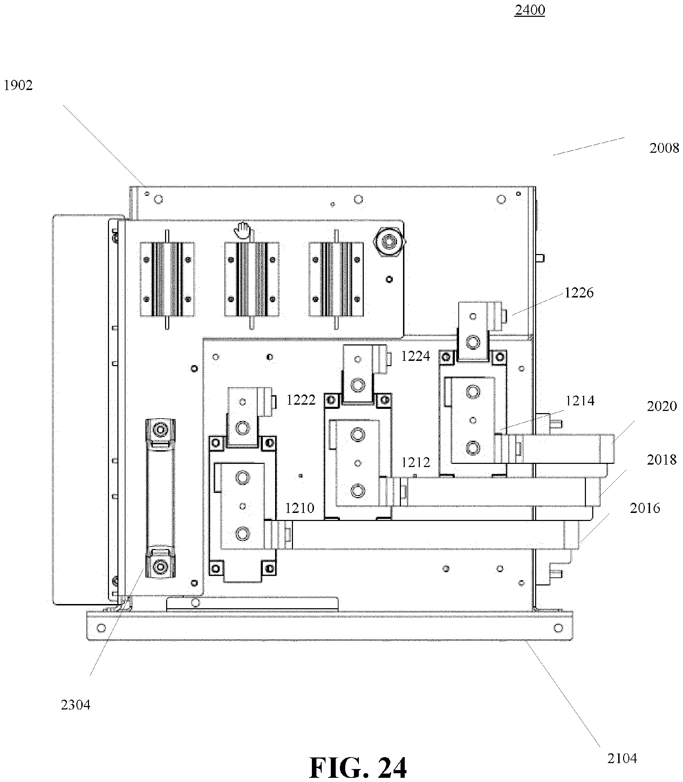

FIG. 24 is a right side view of the electrical system of FIG. 20 according to an exemplary embodiment of the present disclosure. As shown in FIG. 24, there are the inputs (1222, 1224, and 1226) and outputs (1210, 1212, and 1214) of the SCRs for the three power phases of the smaller STS assembly 1904 on the right side 2008. Further, the outputs (1210, 1212, and 1214) are connected through the busbars (2016, 2018, and 2020) on the back of the plenum structure 2104 for the electrical system 1902. The details of the inputs and outputs can be referenced to the descriptions herein according to FIG. 10 and FIG. 21.

As shown, there is a handle, for example, the handle 2304 on the right side 2008 of the plenum structure 2104. The handle 2304 is used to open the front of the plenum structure 2104 for the electrical system 1902 so that the inputs (1222, 1224, and 1226) of the SCRs can be accessed conveniently.

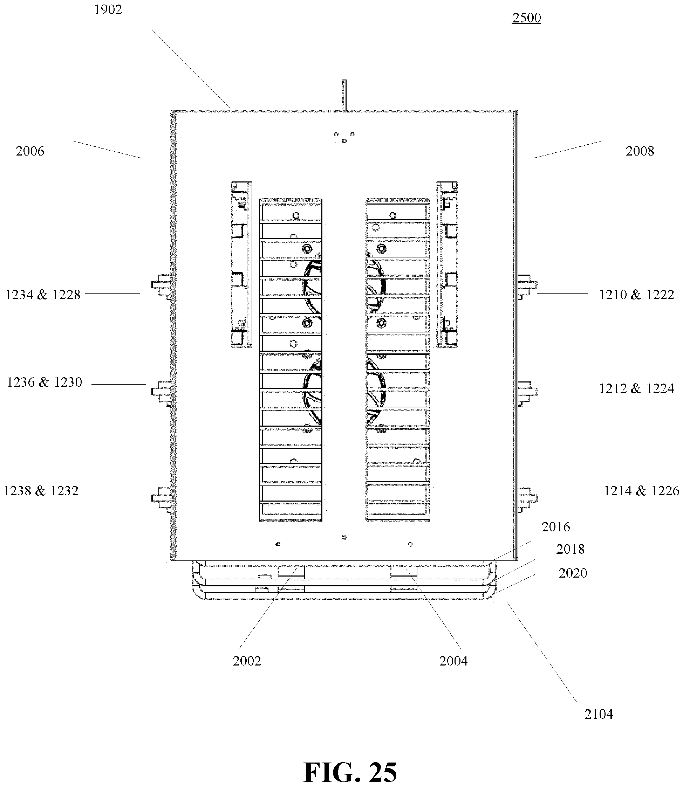

FIG. 25 is a bottom view of the electrical system of FIG. 20 according to an exemplary embodiment of the present disclosure. As shown in FIG. 25, the outputs (1234, 1236, and 1238) and inputs (1228, 1230, and 1232) of the SCRs for the three power phases of the smaller STS assembly 1904 overlap on the left side 2006. The outputs (1210, 1212, and 1214) and inputs (1222, 1224, and 1226) of the SCRs for the three power phases of the smaller STS assembly 1904 overlap on the right side 2008. The details of the inputs and outputs can be referenced to the description herein according to FIG. 11 and FIG. 20.

As shown, the heatsink assemblies (the bottoms thereof are shown) physically isolates the SCRs for the three power phases of the smaller STS assembly 1904 on the left and right sides (2006 and 2008). At the same time, the outputs (1234, 1236, and 1238) on the left side 2006 and the outputs (1210, 1212, and 1214) on the right side 2008 are connected through the busbars (2016, 2018, and 2020) on the back of the plenum structure 2104 for the electrical system 1902. Further, the outputs 2002 and 2004 of the heatsink assemblies are also connected through the busbars (2016, 2018, and 2020). As such, one common output for the outputs 2002 and 2004 of the heatsink assemblies is provided to the electrical system.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the disclosure and does not pose a limitation on the scope of the disclosure unless otherwise claimed. No language in the specification should be construed as indicating any non-claimed element as essential to the practice of the disclosure.

Exemplary embodiments of the present disclosure are described herein, including the best mode known to the inventors for carrying out the disclosure. Variations of those exemplary embodiments may become apparent to those of ordinary skill in the art upon reading the foregoing description. The inventors expect skilled artisans to employ such variations as appropriate, and the inventors intend for the disclosure to be practiced otherwise than as specifically described herein. Accordingly, the present disclosure includes all modifications and equivalents of the subject matter recited in the claims appended hereto as permitted by applicable law. Moreover, any combination of the above-described elements in all possible variations thereof is encompassed by the disclosure unless otherwise indicated herein or otherwise clearly contradicted by context.

## Claims

1. An electrical system, comprising:
a static transfer switch (STS) assembly, comprising at least two silicon controlled rectifiers (SCRs) for at least one power phase of the STS assembly, wherein the at least two SCRs are for incoming power sources that are opposing to each other; and
a cooling system located between the at least two SCRs for the at least one power phase of the STS assembly.

2. The electrical system of claim 1, wherein the cooling system comprises one or more heatsink assemblies for the STS assembly.

3. The electrical system of claim 2, wherein the cooling system comprises a first heatsink assembly located on a first side and a second heatsink assembly located on an opposing second side respectively for the at least two SCRs for the incoming power sources that are opposing to each other.

4. The electrical system of claim 3, wherein the first and second heatsink assemblies are arranged to define a barrier between the at least two SCRs for the incoming power sources that are opposing to each other for the at least one power phase of the STS assembly, and
wherein outputs of the at least two SCRs for the opposing incoming power sources are connected through busbars on a back of the electrical system.

5. The electrical system of claim 2, wherein the cooling system comprises a shared channel for cooling air for the one or more heatsink assemblies.

6. The electrical system of claim 5, wherein the shared channel is a structural part of a plenum structure that supports the electrical system.

7. The electrical system of claim 2, wherein the one or more heatsink assemblies are removeable from a front of the electrical system.

8. A plenum structure for an electrical system, comprising:
a base comprising a first end and an opposing second end;
a first supporting panel comprising a first end and a second end, wherein the first end of the first supporting panel is mounted on the first end of the base;
a second supporting panel comprising a first end and a second end, wherein the first end of the second supporting panel is mounted on the opposing second end of the base; and
a covering layer comprising a first end and a second end, wherein the second end of the first supporting panel is mounted on the first end of the covering layer, and the second end of the second supporting panel is mounted on the second end of the covering layer, and
wherein one or more tracks are mounted on the base for one or more heatsink assemblies of the electrical system within space between the base and the covering layer.

9. The plenum structure of claim 8, wherein the first supporting panel is perpendicular to the base and the second supporting panel is perpendicular to the base, and
wherein the first supporting panel is perpendicular to the covering layer and the second supporting panel is perpendicular to the covering layer.

10. The plenum structure of claim 9, wherein a static transfer switch (STS) assembly is arranged around the one or more heatsink assemblies within the space between the base and the covering layer.

11. The plenum structure of claim 10, wherein the STS assembly comprises at least two silicon controlled rectifiers (SCRs) for at least one power phase of the STS assembly,
wherein the at least two SCRs are for incoming power sources that are opposing to each other, and the at least two SCRs for the opposing incoming power sources are arranged around the one or more heatsink assemblies, and
outputs of the at least two SCRs for the opposing incoming power sources are connected through busbars on a back of the plenum structure.

12. The plenum structure of claim 9, further comprises two front doors to access the one or more heatsink assemblies.

13. The plenum structure of claim 9, wherein the covering layer is a cuboid without top and bottom surfaces, and the cuboid comprises one or more fans for cooling air for the one or more heatsink assemblies.

14. An electrical system, according to claim 1,
wherein the cooling system is located between the at least two SCRs for the incoming power sources that are opposing to each other for the at least one power phase of the STS assembly; and
a plenum structure, and
wherein the cooling system is mounted in a middle of the plenum structure, and the STS assembly is arranged around the cooling system.

15. The electrical system of claim 14, wherein the plenum structure provides both a supporting structure for mounting the cooling system as well as an arrangement of the one or more heatsink assemblies that prevents a failure of one of the at least two SCRs for one incoming source of power to propagate to the other of the at least two SCRs for another incoming source of power.
